(19) **Europäisches Patentamt / European Patent Office / Office européen des brevets**

(11) **EP 4 317 541 A1**

(12) **EUROPEAN PATENT APPLICATION**
published in accordance with Art. 153(4) EPC

(43) Date of publication:
**07.02.2024 Bulletin 2024/06**

(21) Application number: **22773949.7**

(22) Date of filing: **18.02.2022**

(51) International Patent Classification (IPC):
**C30B 15/02** (2006.01)   **C30B 15/00** (2006.01)
**C30B 15/20** (2006.01)   **C30B 29/06** (2006.01)

(86) International application number:
**PCT/CN2022/076754**

(87) International publication number:
**WO 2022/199287 (29.09.2022 Gazette 2022/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.03.2021   CN 202110301214**

(71) Applicant: **Shanghai Yinwan Photoelectric Technology Co., Ltd**
**Shanghai 200331 (CN)**

(72) Inventor: **DING, Xin**
**Shanghai 200331 (CN)**

(74) Representative: **Qip Patentanwälte**
**Dr. Kuehn & Partner mbB**
**Goethestraße 8**
**80336 München (DE)**

(54) **MOLTEN SILICON FEEDER FOR CONTINUOUS CZOCHRALSKI SINGLE CRYSTALS**

(57)    A molten silicon feeder for continuous czochralski single crystals includes an open crucible having a top opening located at the top and an injection port located in the lower part, the open crucible receiving and accommodating a solid silicon raw material; a heater for heating the open crucible, so that the solid silicon therein is melted, and injected below through the injection port at the bottom of the open crucible; a shell for enclosing and vacuum-sealing the overall structure of the molten silicon feeder.

FIG. 1A

**Description**

TECHNICAL FIELD

This technology is in the field of monocrystalline silicon czochralski technology. In particular, the present invention relates to molten silicon feeder for continuous czochralski single crystals.

RELATED ART

The Czochralski technology is a crystal growth method used to obtain the single crystal materials such as semiconductors, metals, salts and synthetic gemstones. The original Czochralski method is a single pull method, in which a crystal rod is drawn from a crucible, and after drawing, the crucible will be cooled to room temperature then broken which cannot be reused.

At present, the industrial production of monocrystalline silicon often adopts the multiple charge multiple pull method, which is improved from the single pull method by adding a feeding device on the equipment. In the multiple charge and multiple pull method, after each pulling of the silicon crystal rod, the crucible shall be kept in a high temperature, and polycrystalline silicon particle raw material (or crushing material from Siemens method) is added batch by batch to the remaining silicon melt in the crucible through a repeated feeding device for melting, which is used for the next pulling of the silicon crystal rod. The multiple charge and multiple pull method will not cause the crucible to rupture due to cooling like the single direct pulling method, making the crucible usable multiple times during its lifespan.

At present, multiple charge multiple pull method is the mainstream application. A further improvement from multiple charge multiple pull method, i.e., the method of continuously adding polycrystalline silicon raw materials during the crystallization process, is called the continuous Czochralski method. The quality of the silicon crystal ingot produced by the continuous CZ method is high, and resistivity is more uniform and the distribution is narrower, making it more suitable for efficient battery processes such as P-type PERC and more efficient N-type battery processes, which is more conducive to the production of high-power components. In view of multiple factors such as efficiency, quality, and cost, the CCZ method will gradually replace the multiple charge multiple pull method."

In the meanwhile, in the CZ process of the silicon single crystal, the oxygen atoms (oxygen atoms are components of quartz) and other impurities of the quartz crucible will penetrate into the silicon melt under the high temperature molten silicon. In the P type solar cell, doped boron and oxygen atoms will form so called B-O complex to reduce the efficiency of the cell. In electronic grade single crystal silicon wafers, Oxygen precipitation is the root cause of COP defect. In the integrated circuit industry, magnetic fields MCZ (magnetic field Czochralski) are mainly used to reduce COP. In a magnetic field, high-temperature molten silicon acts as a conductor to cut magnetic field lines, resulting in Lorentz forces that hinder the convection of the melt and reduce the number of oxygen atoms entering the crystal, thereby reducing oxygen precipitation and ultimately suppressing the generation of COP.

Although magnetic field MCZ has good effects, its price and cost are extremely staggering. In addition to magnetic field power consumption, superconducting coils also require low-temperature excitation, which is also very expensive.

The crystal rod produced by the continuous Czochralski method has better quality, more uniform resistivity, and narrower distribution. The above beneficial effects have significant implications for the application of solar cells and electronic grade chips. However, its biggest effect lies in the use of shallow crucibles in the continuous Czochralski crystal process, which have a significant convective suppression effect and a significant inhibitory effect on the original defects of COP (crystal originated particle). Therefore, high-quality 12 inch integrated circuit large silicon wafers can be manufactured.

At present, the main continuous Czochralski methods in the industry are developed by Solaicx and Confluence Solar, respectively. The former was acquired by MEMC, and the latter became part of GT Advanced Technology.

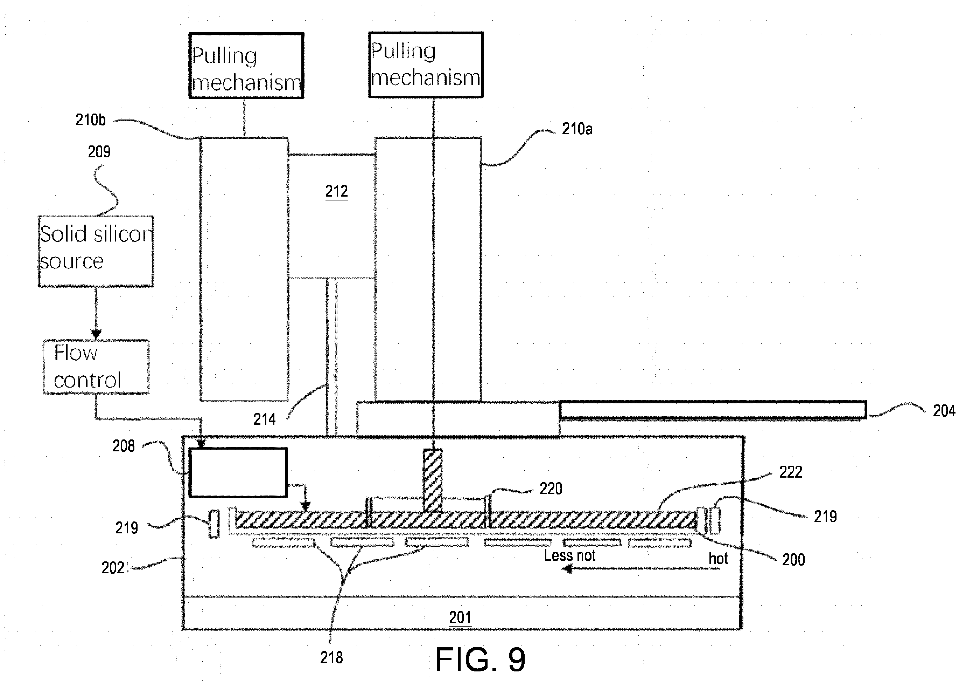

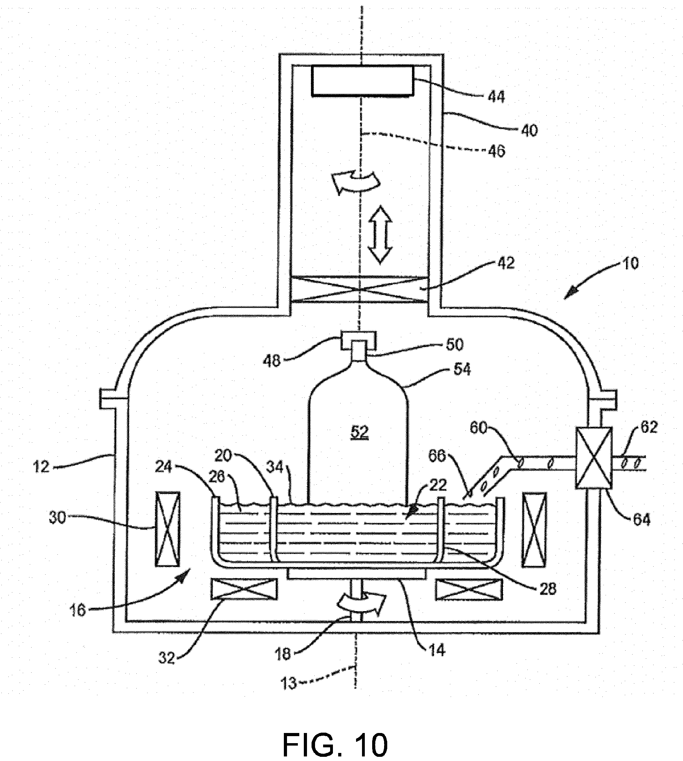

Figure 9 shows a cross-sectional schematic diagram of a continuous Czochralski single crystal furnace according to prior art. Figure 10 shows a cross-sectional schematic diagram of another type of continuous Czochralski single crystal furnace according to prior art. As shown in Figures 9 and 10, the single crystal furnace is surrounded by an outer shell, which is in a vacuum state. Solid silicon raw materials are continuously added to the crucible of the single crystal furnace from the outside through a conveying device.

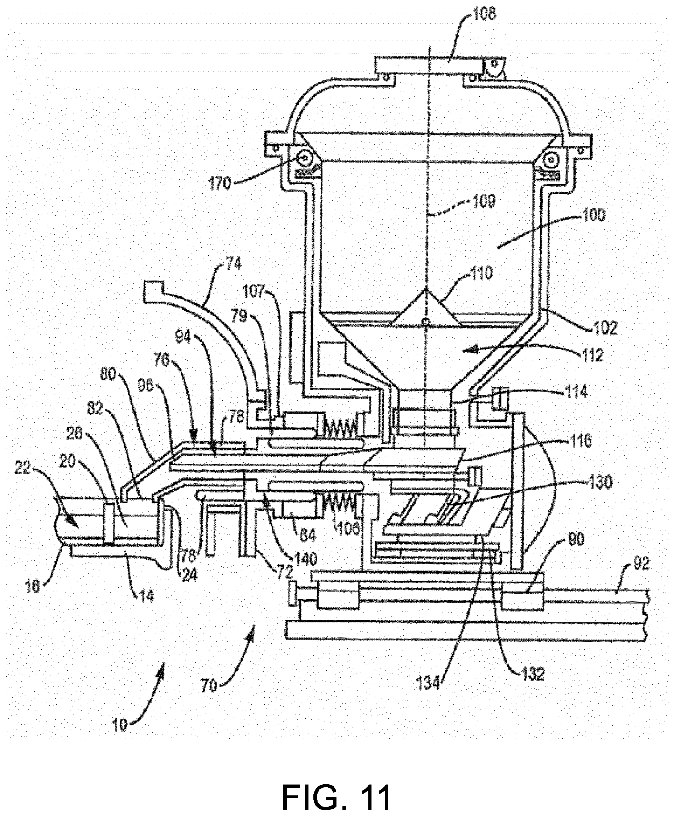

However, the above mentioned CCZ methods are all based on feeding solid polysilicon materials to the crucible and continuous feeding of solid polysilicon materials is based on the premise that the solid polysilicon materials meet certain requirements for maximum particle size and even flowability, so that the feeding can be controlled through vibration or flipping devices. For example, GTAT company provides a vibration conveying device for continuous Czochralski equipment, as shown in Figure 11, in which the physical dimensions of the transported solid polysilicon materials must meet the critical dimensional requirements of the transportation channel to avoid being blocked or stuck.

Generally speaking, the quality of granular silicon with good flowability available in the industry that can be continuously fed is poor. The output is small, and the feeding cannot exceed 20% of the total feeding amount. The polysilicon produced by the Siemens method is in a rod shape, and the shape after crushing is irregular large block shaped with some fine particles mixed in. If the size of blocky polysilicon is too large, further crushing is required to obtain small particles of polysilicon for continuous feeding control through traditional mechanical feeding devices, which include vibrating hoppers and flap valve ports. The hardness of polysilicon is very high, and the crushing process will result in the loss of small particles generated. If a large number of particles that meet the flowability requirements are crushed for flowability, more powder will be lost, with losses ranging from 1% to 5%. The crushing process expands the specific surface area (ratio of surface area to volume) and also brings various potential surface pollution. Common wet chemical cleaning can remove surface pollution, but the chemicals used not only cause environmental pollution, but also cause a certain proportion of silicon to be lost due to corrosion. Therefore, the ability to use Siemens polysilicon rods or blocks close to the original size is a requirement for the continuous Czochralski single crystal method, so that the use of molten silicon for feeding become a choice. However, the current fluid control (valve, pipeline) technology cannot meet the requirements of high purity under high-temperature molten silicon conditions.

## SUMMARY OF INVENTION

In view of the problem that granular silicon and Siemens polycrystalline silicon in the existing technologies mentioned above either cannot meet the quality requirements or cannot meet the flowability requirements for continuous feeding, while fluid control technology cannot meet the high purity requirements under high-temperature molten silicon condition, the present invention provides a method for controlling the conveying speed of molten silicon through a material melting crucible heater without using traditional valve technology. And the content of single crystal oxygen atoms is controlled by crucible design.

According to one embodiment of the present invention, a molten silicon feeder for continuous czochralski single crystals is provided, comprising:

an open crucible having a top opening located at the top and an injection port located in the lower part, the open crucible receiving and accommodating a solid silicon raw material;
a heater for heating the open crucible, so that the solid silicon therein is melted, and injected below through the injection port at the bottom of the open crucible;
a shell for enclosing and vacuum-sealing the overall structure of the molten silicon feeder.

In one embodiment of the present invention, the molten silicon feeder for continuous czochralski single crystals further comprises a feeding port for feeding and transportation by vibrating, flap hopper.

In one embodiment of the present invention, the molten silicon feeder for continuous czochralski single crystals further comprises:
a hopper, that is a container for holding solid polysilicon raw materials, the bottom of the hopper having a bottom opening, the bottom opening of the hopper being docked with the top opening of the open crucible.

In one embodiment of the present invention, the material of the hopper is quartz or a high-purity material resistant to molten silicon erosion, or the inner surface of the hopper has a high-purity material coating resistant to molten silicon erosion.

In one embodiment of the present invention, the hopper further comprises:
a pusher above the hopper to push the solid silicon inside the hopper to an open crucible or to indicate the height of the solid silicon.

In one embodiment of the present invention, the molten silicon feeder for continuous czochralski single crystals further comprises a silicon material plug disposed on the bottom opening of the hopper, such that when carrying the hopper, the solid silicon material will not fall from the bottom opening of the hopper, and the silicon material plug comprises a silicon wafer, silicon block, a key with a convex, a pin, a tooth or a tenon and tenon structure that fits the hopper opening.

In one embodiment of the present invention, the silicon material comprises crystalline silicon, silicon alloy or germanium, germanium alloy, master alloy of three, five group doped material.

In one embodiment of the present invention, the heater is disposed on the periphery of an open crucible, the heater comprises a plurality of independently controlled heaters, the heater is an induction coil heater or a resistance heater of a high-temperature resistant material.

In one embodiment of the present invention, the heater controls the melting speed of solid silicon to control the position and pressure of the molten silicon liquid level and the outlet pressure of the injection port,

wherein the speed of molten silicon injection into the crucible is controlled according to the position and pressure of the molten silicon liquid level and the outlet pressure of the injection port, expressed as the following formula:

$$gz_1 + \frac{u_1^2}{2} + \frac{p_1}{\rho} + w_e = gz_2 + \frac{u_2^2}{2} + \frac{p_2}{\rho} + w_f$$

wherein g indicates the acceleration of gravity, $\rho$ indicates the density of molten polysilicon, $z_1$ indicates the height of the molten silicon liquid level position, $u_1$ indicates the flow velocity at the molten silicon liquid level position, $p_1$ indicates the pressure at the molten silicon liquid level position, $z_2$ indicates the height of the injection port outlet, $u_2$ indicates the injection velocity, $p_2$ indicates the pressure of the injection port outlet, $w_e$ indicates the external work of the molten silicon feeder during the injection process, and $w_f$ indicates the loss of flow resistance.

In one embodiment of the present invention, the molten silicon feeder for continuous czochralski single crystals further comprises:
a water-cooling device disposed on a shell adjacent to the heater.

In one embodiment of the present invention, the molten silicon feeder for continuous czochralski single crystals further comprises: an isolation device disposed at the connection position of the hopper and the open crucible, when the isolation device is closed, the inside of the shell is isolated into two airtight spaces, so that the hopper is airtight isolated from other devices, when the isolation device is opened, the two airtight spaces are connected, the bottom opening of the hopper is docked with the top opening of the open crucible, and the isolation device includes a body flange or an isolation valve.

In one embodiment of the present invention, the upper part of the open crucible is a material melting zone, the lower part is an overheated zone, the injection port is at the bottom of the overheated zone, the top opening size of the open crucible is greater than the size of the injection port, the material melting zone directly melts the solid silicon raw material, the overheated zone overheats the molten silicon, and the diameter of the injection port is between about 1mm and 100mm.

According to another embodiment of the present invention, a solid silicon feeding method utilizing the molten silicon feeder for continuous czochralski single crystals is provided, comprising:

placing a molten silicon feeder above a monocrystalline silicon crucible;
placing solid polysilicon in the hopper, and inserting the bottom of the hopper into an open crucible to transport the solid polysilicon to the open crucible;
heating the solid polysilicon in an open crucible to melt;
overheating the molten polysilicon in an open crucible and injecting the overheated molten polysilicon into the monocrystalline silicon crucible; and
when the hopper needs to be replaced,
closing the isolation device to isolate the hopper;
introducing gas to balance the air pressure in the space where the hopper is located with the outside atmospheric pressure;
removing the hopper and inserting another hopper full of solid polysilicon;
vacuum the space where another hopper full of solid polysilicon is located to balance the pressure and opening the isolation device; and
docking another hopper full of solid polysilicon in the open crucible, turning on the heater to melt the silicon material plug at the bottom of the hopper, and entering the solid silicon material above the plug into the open crucible.

In another embodiment of the present invention, two or more molten silicon feeders are disposed in parallel, to fill the same crystal growing crucible in turn.

According to still another embodiment of the present invention, a hopper of molten silicon for continuous czochralski single crystals is provided, comprising:

a container for holding solid polysilicon raw materials;
a bottom opening at the bottom of the container.

In still another embodiment of the present invention, the hopper further comprises:

a pusher above the hopper to push the solid silicon inside the hopper to the open crucible; and/or
a feeding port for feeding and conveying hoppers or open crucibles by vibrating, flap hopper.

In still another embodiment of the present invention, the material of the hopper is quartz or high-purity ceramic or a material containing a high-purity coating.

In still another embodiment of the present invention, the hopper further comprises a silicon material plug disposed on the bottom opening of the hopper, the silicon material plug comprising a silicon wafer, silicon block, raised key, pin, tooth or mortise structure of the same diameter as the hopper.

In still another embodiment of the present invention, the diameter of the hopper is greater than the diameter of the native polysilicon rod of the Siemens method reduction furnace, and the diameter of the native polysilicon rod is 100-200mm.

The present invention not only achieves better quality of silicon rod using continuous czochralski technology, more uniform of resistivity and narrow distribution, but also is more suitable for efficient battery processes such as P-type PERC and more efficient N-type battery processes, which is more conducive to the production of high-power components. In addition, the present invention solved the problems, such as the poor flowability, poor transportation performance of Siemens method polysilicon block material that is continuously puzzling the continuous czochralski technology, difficulty in continuous and stable feeding, poor quality of particle materials with good transport performance, low production, and inability to fully feed particle materials. The present invention can directly add the polycrystalline silicon rod obtained after dismantling the Siemens reduction furnace into the hopper without crushing, in order to improve production efficiency, reduce the chance of silicon pollution, and reduce costs. At the same time, the present invention can significantly reduce the oxygen content of Czochralski single crystals, reduce the COP native defects and boron oxygen complexes caused by oxygen, thereby improving the performance of electronic silicon wafers and improving the conversion efficiency of solar cells.

BRIEF DESCRIPTION OF DRAWINGS

In order to further clarify the various embodiments of the present invention and other advantages and features, reference will be made to the accompanying drawings to present a more specific description of each embodiment of the present invention. It is understood that these drawings only depict typical embodiments of the present invention and will therefore not be considered a limitation of its scope. In the drawings, for clarity, identical or corresponding parts will be indicated by identical or similar markings.

FIG.1A shows a schematic diagram of a molten silicon feeder in one embodiment of the present invention.

FIG. 1B shows a variant of the molten silicon feeder shown in FIG. 1A according to one embodiment of the present invention.

FIG.2 shows a schematic diagram of the structure of a continuous czochralski single crystals furnace for continuous czochralski single crystals in one embodiment of the present invention.

FIG.3 shows a schematic diagram of the structure of a hopper in one embodiment of the present invention.

FIG.4 shows a schematic diagram of the shape of the hopper bottom plug in one embodiment of the present invention.

FIG.5 shows a flowchart of a quick material change in one embodiment of the present invention.

FIG.6 shows a convection situation in a monocrystalline silicon crucible in one embodiment of the present invention.

FIG.7A shows a schematic diagram of a shallow crucible and an inner dam thereof according to one embodiment of the present invention.

FIG.7B shows a schematic diagram of a shallow crucible and an inner dam thereof according to another embodiment of the present invention.

FIG.8A shows a schematic diagram of a shallow crucible and an inner dam thereof according to one embodiment of the present invention.

FIG.8B shows a schematic diagram of a shallow crucible and an inner dam thereof according to another embodiment of the present invention.

FIG.9 shows a cross-sectional schematic diagram of a continuous Czochralski single crystal furnace according to prior art.

FIG. 10 shows a cross-sectional schematic diagram of another type of continuous Czochralski single crystal furnace according to prior art.

FIG. 11 shows a schematic diagram of a vibration conveying device of a continuous CZ device according to prior art.

DESCRIPTION OF EMBODIMENTS

It should be noted that the components in the drawings may be exaggerated for illustrative purposes and not necessarily in the correct proportions. In each drawing, the same or functionally identical components are equipped with the same drawing markers.

In the present invention, unless otherwise indicated, "arranged in... on", "Arranged in... above" as well as "arranged in... "above" does not exclude the existence of intermediaries between the two. In addition, "arranged in... Up or Above" simply indicates the relative position relationship between two parts, and in certain cases, such as after reversing the product orientation, it can also be converted to "arranged in... below or below" and vice versa.

In the present invention, each embodiment is only intended to illustrate the scheme of the present invention, and should not be understood as restrictive.

In the present invention, unless otherwise indicated, the quantifiers "one", "one" do not exclude the scene of multiple elements.

It should also be noted here that in embodiments of the present invention, for clarity and simplicity, only a portion of the components or assemblies may be shown, but those of ordinary skill in the art can understand that under the teaching of the present invention, the required components or assemblies may be added according to the needs of the specific scene. Further, unless otherwise indicated, the features in different embodiments of the present invention may be combined with each other. For example, a feature in the second embodiment may replace the corresponding or functionally identical or similar feature in the first embodiment, and the resulting embodiment also falls within the scope of disclosure or description of the present application.

It should also be noted here that within the scope of the present invention, the words "same", "equal", "equal" and the like do not mean that the two values are absolutely equal, but allow a certain reasonable error, that is, the wording also covers "substantially the same", "substantially equal", "substantially equal". By analogy, in the present invention, the terms "perpendicular to", "parallel to", etc. in the table direction also cover the meaning of "substantially perpendicular to", "substantially parallel to".

Further, the number of steps of each method of the present invention does not limit the order in which the method steps are performed. Unless otherwise noted, method steps can be performed in different orders.

The present invention is further elaborated below with reference to the accompanying drawings in conjunction with specific embodiments.

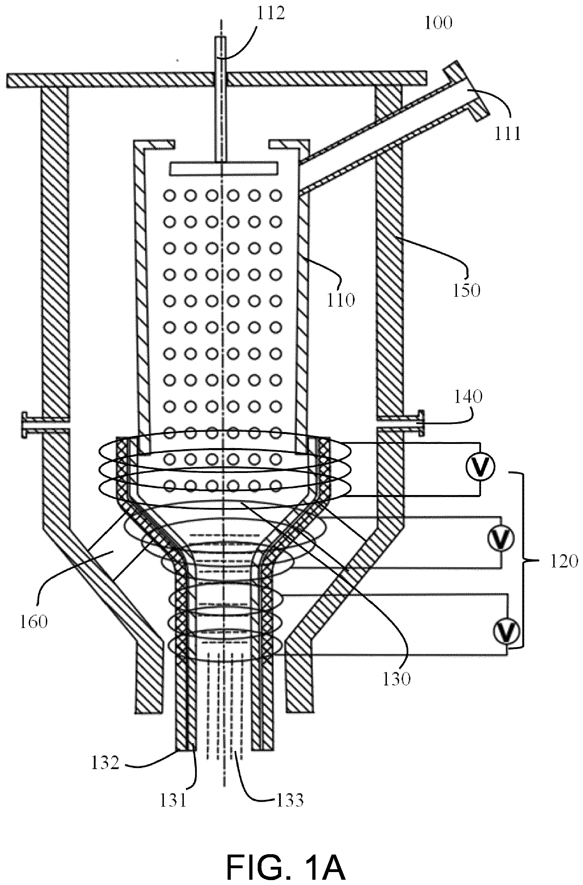

An embodiment of the present invention proposes a molten silicon feeder 100 having three working regions, as shown in FIG.1A. The molten silicon feeder 100 includes a hopper 110, a heater 120, an open crucible 130, an isolation device 140, a shell 150.

The inner wall of the feeder 100 (including the inner layer of the hopper 110 and the inner layer 131 of the open crucible 130) is a high-purity material with high temperature resistance. The high-purity material with high temperature resistance includes quartz, high-purity ceramics or high-purity materials resistant to molten silicon corrosion, and materials with high-purity coatings resistant to molten silicon corrosion. An open crucible means that the crucible has an opening in the lower part, so that it can only dynamically hold molten silicon, so that it can continuously replenish molten silicon to the crystal growth crucible at a given rate. Lower openings include openings located at the bottom, or lateral openings in the lower part of the side. Due to their small size, open crucibles do not need to withstand the gravity of a large amount of molten silicon, and silicon nitride ceramics can be used. Silicon nitride is non-wetted with melt silicon and does not contain oxygen, which helps reduce the entry of oxygen atoms into the melt, which can improve the COP of electronic grade single crystals and the boron-oxygen composite of solar silicon wafers.

The working zone of the feeder 100 includes a solid raw material zone, a material melting zone and an overheated zone. The hopper 110 is in the solid raw material zone. The bottom opening of the hopper 110 is docked or partially overlapped with the top opening of the open crucible 130. The outer layer 132 of the open crucible 130 is a heat insulation material, such as graphite, carbon felt composite or ceramic refractory material. In some cases, the outer layer 132 is not a necessary design (for example, when the material of 131 is quartz, the quartz softens under the temperature conditions of molten silicon, and may crack after cooling, so the outer layer 132 is required to physically support and protect the quartz (to prevent molten silicon leakage). If the outer heater is an induction coil, the induction coil cannot be directly exposed to high temperatures, and it is also possible to rely on the insulation material of outer layer 132 to isolate the high temperature crucible, and generally speaking, the induction coil itself needs to be water-cooled. ), if the graphite resistance heater is used like the conventional czochralski single crystal furnace, the heat insulation material needs to be disposed outside the heater 120 to insulate the heater. In this case, if 131 is made of quartz, 132 is still required as a physical support and protection for 131. The heater 120 is disposed outside the open crucible 130, and heats the silicon inside the open crucible 130. The upper part of the open crucible 130 is in the material melting zone, and the lower part is in the overheated zone. In some embodiments of the present invention, the diameter of the hopper 110 is configured to be appropriately larger than the diameter of rod-like silicon (the original rod of the polysilicon reduction furnace is typically 100mm to 200mm), which allows for allows for direct injection of the larger Siemens polysilicon into the barrel of the feeder to melt, without limiting to the broken Siemens polysilicon, of course, it can also be equally applicable to granular polysilicon.

In a specific embodiment of the present invention, the hopper 110 may also include a feeding port 111 and a top pusher 112. In the solid raw material zone, the unmolten silicon is transported by gravity or pusher 112 to the lower material melting zone, or the pusher 112 is used to indicate the height of the remaining silicon in the hopper 110.

In some embodiments of the present invention, the heater 120 may include a plurality of independently controlled heaters. Each heater may be an induction coil or a resistive (graphite, silicon carbide or high melting point metal, etc.)

heater. These induction coils or heaters are disposed in the periphery of the material melting zone and the overheated zone of the open crucible 130. There is a certain diameter change from the material melting zone to the overheated zone, so that the material melting zone can directly melt the large piece of native Siemens silicon rod and keep the injection port 133 small in size, and the silicon liquid can enter the monocrystalline silicon crucible according to the set flow rate to complete the growth.

In the embodiment shown in FIG.1A, the heater 120 is three independently controlled induction coils, however, those skilled in the art should understand that the heater of the present invention is not limited to the specific structure shown in FIG.1A. Those skilled in the art can select the type and number of heaters according to the actual heating requirements.

Since high-purity silicon is virtually non-conductive at room temperature, induction coils cannot directly heat silicon at room temperature. Thus, the induction heater 120 needs to be designed with a microwave or resistance heater as part of the silicon preheating, the preheated silicon can be heated by the induction coil, there is also a term for this preconducting process called breakdown. After breakdown, the silicon can be heated by an induction heater. In other embodiments of the present invention, the breakdown heat required for silicon may be introduced by the lower high temperature crystal pulling crucible, so that a portion of the silicon reaches the breakdown temperature and is heated by the induction coil.

In the material melting zone, due to the skin effect of induction heating or uneven heat transfer, there may be a certain solid-liquid mixing phenomenon in this zone.

The rate of silicon melting is controlled by the heating power of the heater 120. The heating power, the minimum diameter of the injection port 133 and the molten silicon liquid level of the injection tube (pressure at the outlet) determine the maximum outflow rate of silicon.

Due to the smaller inner diameter of the opening under the crucible, there can be multiple heaters outward from the center; the heater can be multi-zone independent heater; the power of a single heater is 100W-500KW. The height of molten silicon (outlet pressure) can be adjusted by varying the power of a plurality of independently controlled heater 120. When it is required to increase the speed of silicon injection, increase the power, to further melt the silicon in the high zone, so that the liquid level of molten silicon increases, and the outlet pressure increases to increase the injection speed of silicon. When a smaller silicon injection flow is required, the number of heaters involved can be reduced and only the heaters below are used. The lower part of the open crucible 130 is the overheated zone, the injection port 133 is at the bottom of the overheated zone, the molten silicon flows to the czochralski single crystal furnace crucible, and the molten silicon is properly overheated so that the molten silicon will not condense and cause blockage.

Assuming that a 310mm round bar is drawn, the speed is assumed to be 1mm/min, if the pulling speed increases or decreases, the required outlet injection volume increases or decreases accordingly, as shown in the following table:

Table 1

| Flow (cubic centimeter per minute) | Diameter (millimeter) | Pulling speed (millimeter per minute) |
|---|---|---|
| 75.47694 | 310 | 1 |
| Outlet cross-sectional area (square centimeter) | Injection port diameter (millimeter) | Outlet flow rate (centimeter per minute) |
| 0.7854 | 10 | 96.1 |

The injection port diameter is expanded to 2 cm, and the required outlet flow rate can be reduced to 24 cm/min.

Excessive openings can cause large clumps of silicon liquid or even unmelted silicon blocks to fall directly into the crucible, splashing out of the crucible, causing safety hazards. An opening that is too small may not achieve sufficient flow based on the melting level alone. Thus, an appropriate opening can take into account injection speed, silicon splash and safety. In summary, in an embodiment of the present invention, the opening inner diameter is set between about 1mm to about 100mm.

The melting velocity of the solid polysilicon is controlled by the heating power of the heating zone to control the position and pressure of the molten silicon level and the pressure at the injection outlet.

According to the control of the speed at which molten silicon is injected into a single crystal silicon crucible, it is expressed as follows:

$$gz_1 + \frac{u_1^2}{2} + \frac{p_1}{\rho} + w_e = gz_2 + \frac{u_2^2}{2} + \frac{p_2}{\rho} + w_f$$

wherein g indicates the acceleration of gravity, $\rho$ indicates the density of molten polysilicon, $z_1$ indicates the height of the molten silicon liquid level position, $u_1$ indicates the flow velocity at the molten silicon liquid level position, $p_1$ indicates the pressure at the molten silicon liquid level position, $z_2$ indicates the height of the injection port outlet, $u_2$ indicates the injection velocity, $p_2$ indicates the pressure of the injection port outlet, $w_e$ indicates the external work of the molten silicon feeder during the injection process, and $w_f$ indicates the loss of flow resistance.

The shell 150 encloses and vacuum-seals the hopper 110, the heater 120 and the open crucible 130. When working, the inside of the shell 150 is vacuumed by a vacuum device. The isolation device 140 is disposed at the connection position of the hopper 110 and the open crucible 130. The isolation device 140 is used to isolate hopper 110 from other devices when replacing hopper 110. That is, the isolation device 140 may isolate the interior of the shell 150 into two airtight spaces: an upper hopper space and a lower open crucible space. The isolation device 140 may be an isolation flange, a body flange, a plug-in valve and other airtight devices.

The shell 150 may be a metal container, where a cooling water jacket needs to be added in the section close to the heater.

The open crucible 130 is optionally supported on the shell 150 by an open crucible support unit 160.

When it is required to supplement the feeding hopper, the traditional vibrating and flap hopper can be used for feeding and transportation through the traditional feeding port 111 in the upper right corner, or it can be quickly changed by directly replacing the hopper.

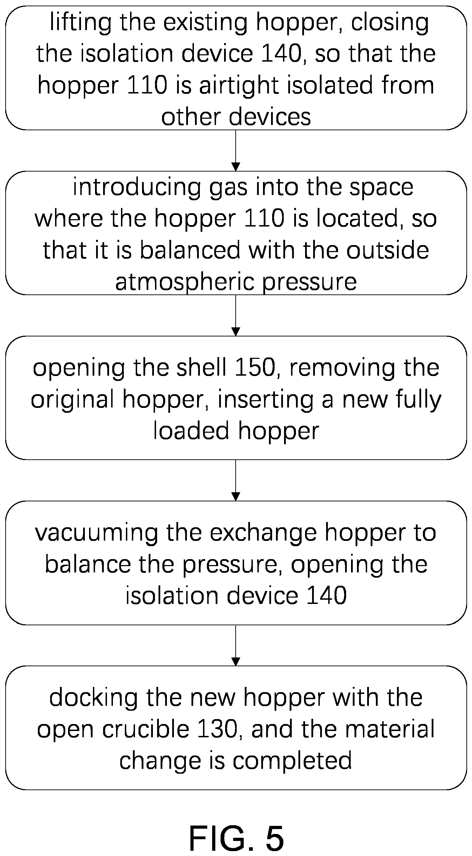

In particular, FIG. 5 illustrates a flowchart of a method for quickly replacing the hopper according to one embodiment of the present invention. Direct replacement hopper comprises: lifting the existing hopper, closing the isolation device 140, so that the hopper 110 is airtight isolated from other devices; introducing gas into the space where the hopper 110 is located, so that it is balanced with the outside atmospheric pressure; opening the shell 150, removing the original hopper, inserting a new fully loaded hopper; vacuuming the exchange hopper to balance the pressure, opening the isolation device 140; docking the new hopper with the open crucible 130, and the material change is completed.

In one embodiment of the present invention, in order to prevent the solid silicon material in the hopper from spilling out when replacing the hopper device, a silicon wafer of the same diameter as the hopper may be used as a disposable bottom plate at the bottom of the hopper, wherein the silicon bottom plate (silicon wafer) with a diameter of less than 300mm is easy to manufacture for the solar industry, and 400mm-600mm czochralski monocrystalline polycrystalline is also a product that can be mass-produced. If ingot technology is used, silicon blocks with a dimension of 1000mm can be easily obtained. When the new hopper is docked with the open crucible, the wafer bottom plate will be melted and the solid silicon can enter the material melting zone.

In other embodiments of the present invention, other shapes of hopper bottom structures may be used, which will be described in detail below.

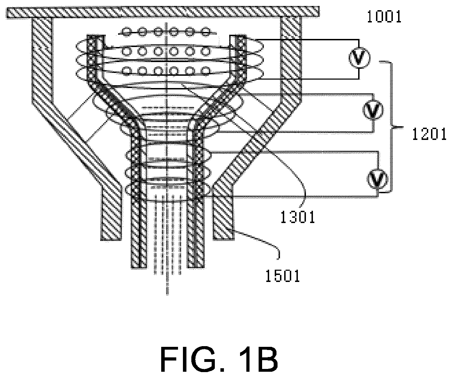

FIG.1B shows a variant of a molten silicon feeder shown in FIG.1A according to one embodiment of the present invention. As shown in FIG.1B, the molten silicon feeder 1001 includes a heater 1201, an open crucible 1301 and a shell 1501. The heater 1201, the open crucible 1301 and the shell 1501 are similar to the corresponding heater 120, the open crucible 130 and the shell 150 shown in FIG. 1A, so it will not be repeated.

The feeder 100 shown in FIG.1B differs from the feeder shown in FIG.1A in that no hopper and isolation device are required. The solid raw material is placed directly in the open crucible.

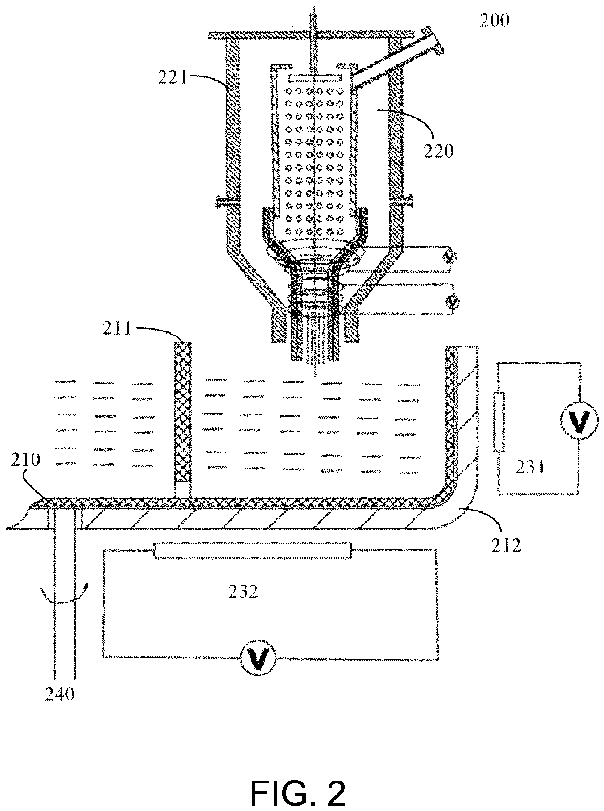

FIG.2 shows a schematic diagram of a czochralski single crystal furnace 200 for continuous czochralski single crystal according to one embodiment of the present invention. The czochralski single crystal furnace 200 includes a crucible 210 and a silicon feeder 220, as shown in FIG.2. Silicon feeder 220 is similar to the molten silicon feeder structure described in conjunction with FIG. 1A, which are not depicted in detail in order to simplify this specification. The silicon feeder 220 is installed above the crucible 210 of the czochralski single crystal furnace, and its shell 221 is a metal connected to the czochralski single crystal furnace shell, or becomes part of the czochralski single crystal furnace, the shell can withstand the necessary vacuum when pulling single crystal. In the embodiment shown in FIG.2, in order to simplify the illustration, only a portion of the crucible and the shell are shown, those skilled in the art can conceive the overall structure of the single crystal furnace based on the partial diagram shown in FIG.2.

Silicon feeder 220 has a heating zone and a hopper (barrel) above, and the hopper is a high-purity material such as high-purity quartz or high-purity ceramics.

Those skilled in the art should understand that the silicon feeder 220 may use the feeder shown in FIG.1B or other types of feeders. As long as the crucible 210 can be supplied with solid or liquid raw materials, it can be used as a feeder for the czochralski single crystal furnace 200 of the present invention. Thus, any feeder that can provide solid or liquid raw materials to the crucible falls within the protection scope of the present invention.

The crucible 210 is a crystal growth crucible similar to the traditional czochralski single crystal technology, to hold molten silicon, and its materials can be quartz, high-purity ceramics, silicon nitride or other high melting point materials. The crucible 210 has a crucible inner dam (or inner weir) 211. The crucible inner dam 211 and the crucible 210 are concentric, and driven by the crucible drive shaft 240 at the bottom to rotate and / or (lift). The crucible dam 211 has an opening in the lower part or an overflow gap on the upper edge, so that the convection inside and outside the dam is isolated from each other and the liquid level is connected. The structure and function of the crucible dam 211 will be described in detail below.

In one embodiment of the present invention, the crucible holder 212 may be provided outside the crucible 210. For example, when the crucible 210 is a quartz crucible, the crucible holder 212 is a graphite, carbon felt composite or ceramic holder. The crucible holder 212 can play a role in support and heat insulation.

At the bottom and sides of the crucible 210, one or more heaters 231, 232 may be provided. Each heater can be an induction coil or a resistance heater such as a resistive heater of graphite, silicon carbide or high melting point metals. The heater can be multi-zone independent heating; the power of a single heater is 100W-500KW.

At the bottom of the crucible 210, a crucible shaft 240 is provided for rotating the crucible. If a metal shell is provided outside the heating zone, the shell needs to be protected by water cooling.

Due to the small size, the inner dam 211 can be easily achieved by using silicon nitride ceramics, which is non-wetted with the melt silicon and does not contain oxygen, which helps to reduce the entry of oxygen atoms into the melt, and can improve the COP of electronic grade single crystals and the boron-oxygen composite of solar silicon wafers. The nitrogen atoms in silicon nitride enter the molten silicon, which can achieve nitrogen-doped single crystals in semiconductors.

The heating zone of the silicon feeder 220 is divided into: a solid feeding zone, a material melting zone (probable solid-liquid mixing zone) and a overheated injection zone; the overheated injection zone injects molten silicon into the crucible; the overheated injection zone may be the downward opening of the open crucible, and the opening diameter is smaller than the hopper diameter (the diameter of the upper opening of the crucible); the portion of the quartz open crucible injection port that is not affected by the gravity of molten silicon can be designed without a crucible holder; The lower inner diameter of the heater (open crucible downward opening) and the upper inner diameter of the heater (open crucible lower opening) are between 1mm and 500mm.

The middle of the silicon feeder 220 has a body flange (body flange) or isolation valve (plug valve, etc.) that can be isolated as an isolation device, so that the upper and lower parts of the valve or flange can be closed or isolated or disassembled after sealing; the body flange or isolation valve can separate the hopper after the polysilicon in the upper hopper is used up, close the valve or isolate the body flange; the inside of the feeder above the flange or valve is recharged to atmospheric pressure and opened, and a new hopper is loaded; the effective inner diameter of the body flange or isolation valve is between 5mm-500mm.

The bottom of the new hopper is a plug made of silicon wafer or silicon material, after the pressure is balanced, open the isolation valve, insert the silicon bottom plate at the bottom of the hopper into the open crucible, and heat it until the silicon bottom plate or silicon plug is melted. Then the second feeding is completed.

In one embodiment of the present invention, 2 or more feeders are used to work alternately to ensure continuous growth through the smallest shallow crucible. Two or more feeders can be placed in different positions above the crucible.

In one embodiment of the present invention, a shallow crucible is used to suppress convection.

In traditional crystal pulling technology, with the growth of crystals and the consumption of molten silicon, when the melt depth in the crucible is different, there are great differences in convection patterns. Especially with the rise of the crucible, the boundary layer of molten silicon and the crucible wall and bottom are in different positions of the hook-shaped magnetic field, and the direction and field strength of the magnetic field will change greatly, resulting in a large change in the convection mode, so the axial and radial oxygen distribution in the crystal becomes a very complex mode. In the continuous czochralski technology, the height of the charge in the crucible is reduced to become the so-called shallow crucible, and the crucible no longer needs to rise significantly to match the decline of the silicon level after the consumption of molten silicon (the consumption of molten silicon is compensated by continuous feeding), and the crystal growth interface is maintained at the same position of the same silicon level height and magnetic field (if there is a magnetic field), thus maintaining the same convection pattern. For a single convection mode, it is easy to optimize the crystal growth parameters, which can make the boundary layer of oxygen diffusion at the bottom of the crucible and the wall of the crucible the thickest and the oxygen diffusion the least. The volatilization of oxygen atoms to the crucible surface by free convection is maximized, so the amount of oxygen atoms entering the crystal growth is minimized.

The Glashchev number G, is a dimensionless number in fluid dynamics and heat transfer, which approximates the ratio of buoyancy to viscous force acting on the fluid, used to characterize the buoyancy-driven natural heat convection caused by the temperature gradient inside the melt, and expressed as follows:

$$G_r = \frac{g\alpha_v \Delta t L^3}{v^2}$$

where $\alpha_v$ represents the coefficient of volume change, for the ideal gas equals to the reciprocal of absolute temperature, g represents the acceleration of gravity, L represents the characteristic scale, and $\Delta t$ is the temperature difference, v represents the kinematic viscosity.

The reason of the primary crystal defect COP is the accumulation of vacancy defects, and the vacancies is caused by the oxygen atoms in the quartz crucible entering the melt through convection and growing and precipitating in the silicon crystals which are an important cause of COP. Reducing the crucible depth can significantly reduce convection, inhibit foreign impurities such as oxygen atoms brought by convection, thereby inhibiting native COP defects; from the formula of Grachav's number $G_r$, it can be seen that when the crucible liquid level decreases, the convection intensity decreases accordingly; the shallow crucible crystal pulling is corresponding to the state when the crystal pulling is close to the end and the molten silicon is about to be exhausted. That is, the shallow crucible can inhibit convection and reduce the oxygen content in the crystal, thereby reducing the COP defect.

Convection is suppressed using a shallow crucible to produce COP-free monocrystalline silicon with a liquid level depth of the liquid molten silicon in shallow crucible less than 1/2 crucible diameter. In the crystal pulling process, the maximum molten silicon amount in the shallow crucible is less than 2/3 of the total molten silicon demand for a single crystal pull, and more than 1/3 of the molten silicon demand for a single crystal pull is supplemented by feeding.

The shallow crucible is used to suppress convection to produce a single crystal without COP in combination with the magnetic field MCZ, wherein the magnetic field includes hooked, horizontal, and vertical magnetic fields.

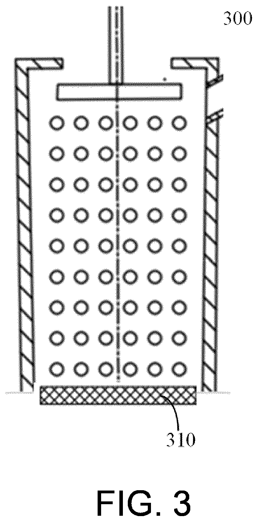

FIG.3 shows a schematic diagram of a hopper 300 according to one embodiment of the present invention. Hopper 300 may use quartz. Polysilicon rod can be directly put into hopper 300. The bottom of the hopper 300 has a silicon plug 310.

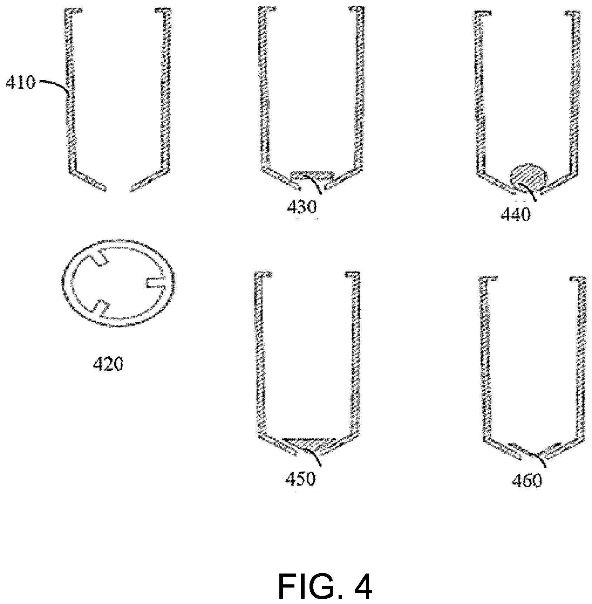

FIG.4 illustrates a schematic diagram of a variety of variants of a hopper according to embodiments of the present invention. As shown in FIG.4, 410 represents a cross-sectional view of the hopper, 420 represents a top view of the hopper, and the plug at the bottom of the hopper has four variants, respectively indicated by 430 to 460. The plug at the bottom of the hopper can be mechanically designed in countless different shapes, including cylindrical, conical, square and inverted trapezoidal.

Raised keys or pins, teeth, and tenon and tenon structures can also be added to the plug.

The plug can be other master alloy material for doping, or a silicon material that is already doped. The plug can be monocrystalline silicon, polysilicon, or even other crystalline state silicon or silicon alloys, and even semiconductor materials such as germanium.

Based on the processing cost of silicon wafers, during transitional processing, the possible pollution to the system by machining equipment, round silicon wafers with an appropriate thickness that can withstand the weight of silicon in the feeding hopper are the best choice for cost, difficulty of implementation and risk of impurity contamination.

Casting polycrystalline (or casting quasi-monocrystalline) makes it easy to obtain large-sized ingots and is an important option for manufacturing plugs (bottom plates).

In one embodiment of the present invention, a silicon nitride crucible inner dam is used to prevent oxygen atoms from the quartz crucible wall and bottom entering into the dam through convection, to produce COP-free single crystals.

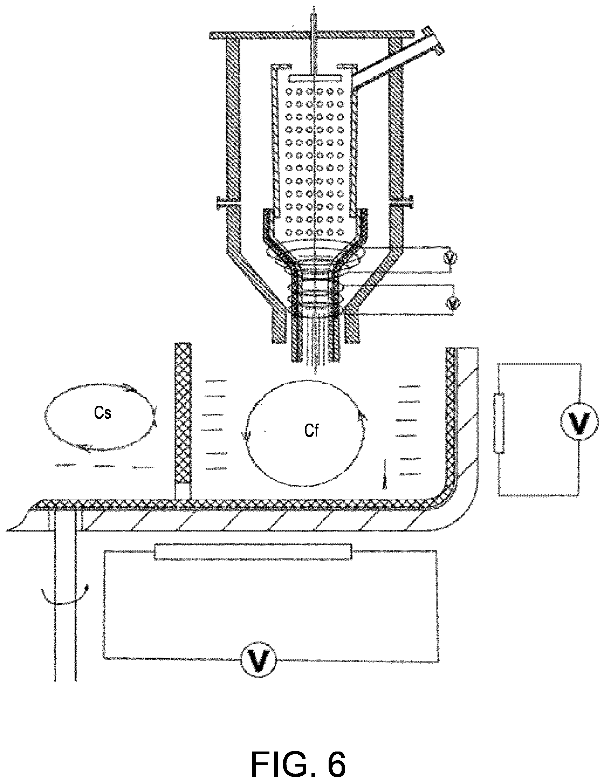

In the process of czochralski single crystal convection, since the molten silicon is extracted and lifted by the czochralski crystal, in combination with the rising buoyancy of natural thermal convection, forced convection is caused by the rotation of the crucible and crystal. The convection of the crucible can be summarized as two mobile cells, Cs and Cf, as shown in Figure 6. The oxygen atoms exchanged into molten silicon come from the crucible bottom and crucible wall. Among them, Cf obtains oxygen atoms at the bottom and side wall of the crucible below, and the oxygen in Cf will volatilize a large amount on the liquid surface of Cf, thereby reducing the oxygen content. The oxygen of Cs comes from the exchange of matter on the crucible bottom below Cs and the interfacial layer of the Cf mobile cell, and finally the oxygen content in the Cs determines the oxygen content of the crystal.

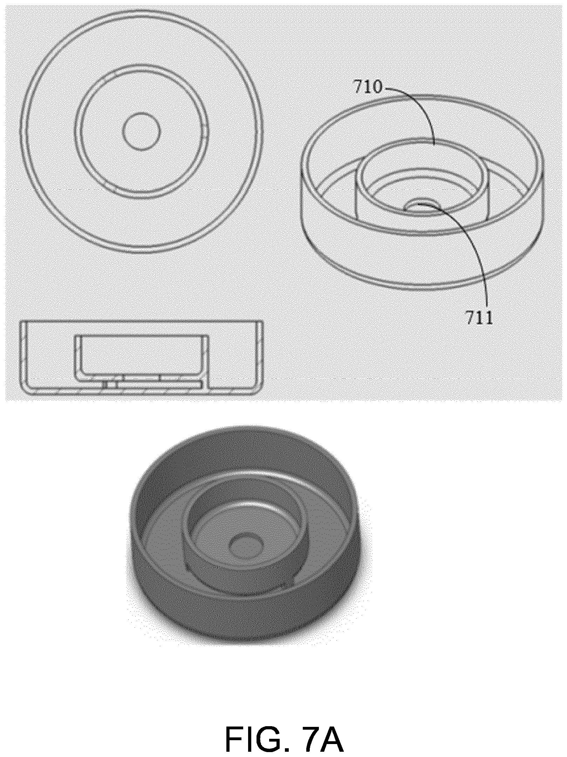

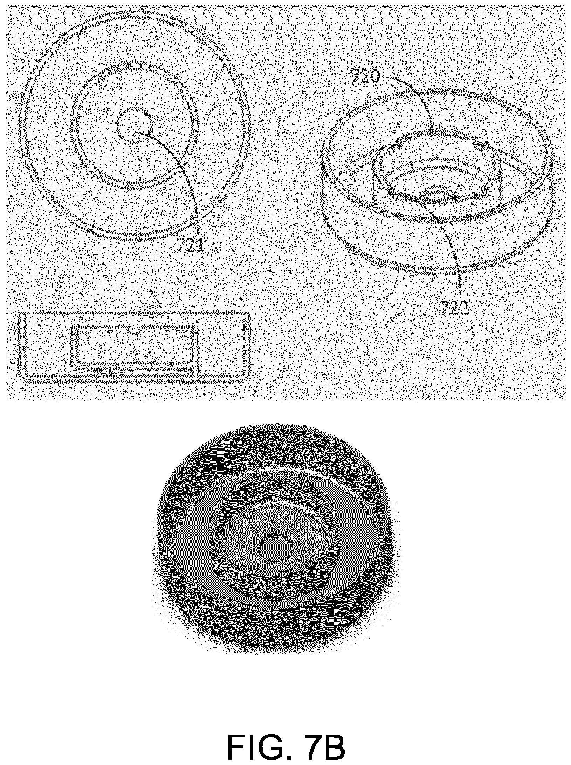

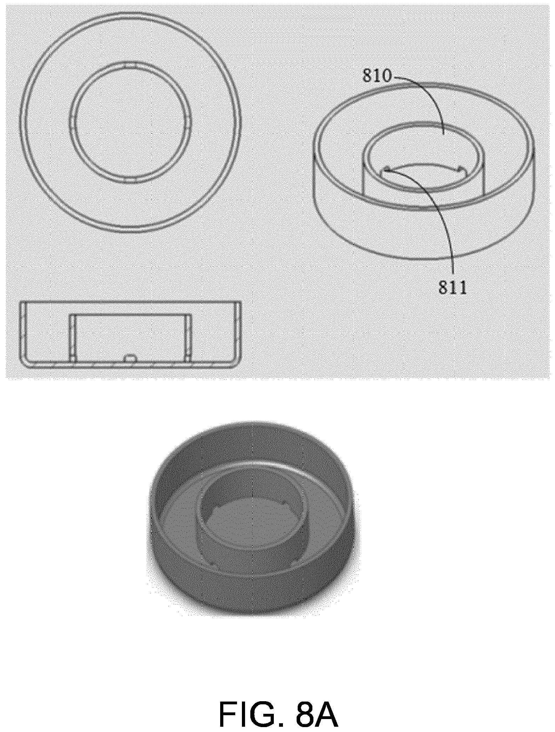

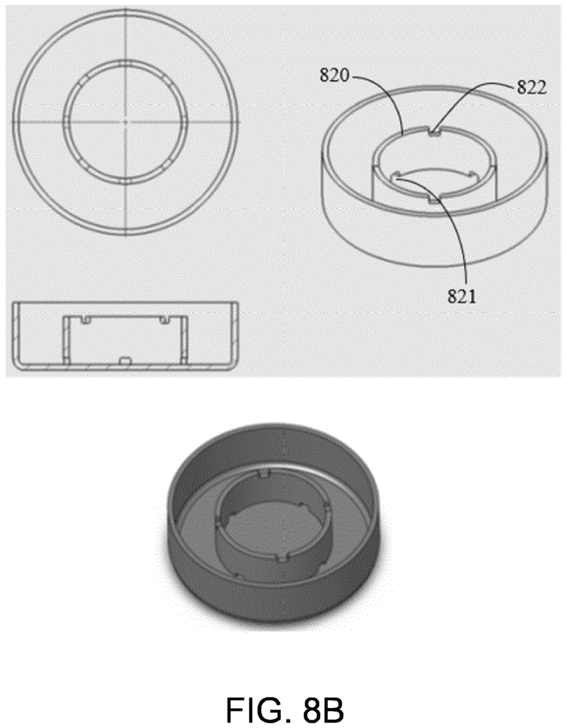

Thus, an embodiment of the present invention uses a dam of silicon nitride material in a shallow crucible to isolate crucible walls and the crucible bottom as many as possible. FIG.7A shows a schematic diagram of a shallow crucible and an inner dam thereof according to one embodiment of the present invention. The inner dam 710 is a U-shaped inner dam with an opening 711 at the bottom. FIG.7B shows a schematic diagram of a shallow crucible and an inner dam thereof according to another embodiment of the present invention. The inner dam 720 is a U-shaped inner dam with openings 721 and 722 at the bottom and side tops. FIG.8A shows a schematic diagram of a shallow crucible and an inner dam thereof according to one embodiment of the present invention. The inner dam 810 has only sidewalls, and the bottom of the sidewall has an opening 811. FIG.8B shows a schematic diagram of a shallow crucible and an inner dam thereof according to another embodiment of the present invention. The inner dam 820 has only sidewalls, and the bottom and bottom of the sidewall have openings 821 and 822. The molten silicon used to compensate for the crystallization consumption only enters through the opening of the dam, that is, the material exchange is limited to the molten silicon entering the inner dam from outside the dam, and its rate is equal to the rate of the crystal growth, and the amount of oxygen atoms entering Cs per unit time is only = the rate of the crystal growth * the oxygen content of melting silicon per unit Cf. The amount of oxygen atoms in Cs = the liquid exchange rate of melt convection * the oxygen content of melted silicon per unit Cf. Since the rate of crystal growth is much lower than the liquid exchange rate of convection of crucible melt, the oxygen content in Cs will be greatly reduced. If the exchange hole of the large inner dam becomes larger such that the liquid exchange rate of melt convection is higher than that of the crystal growth, the specified oxygen atom content in between can be obtained.

The molding process and cost of high-purity materials resistant to high temperature molten silicon erosion have always been a problem in the industry. Based on the principles of the present invention, various complex shapes may be designed to achieve the purpose of controlling the exchange of fluid substances described above. Practitioners in the industry should and can understand that the design of these special-shaped dams is within the scope of the present invention. However, combined with industrial practice, cost and feasibility, the open cylinder or U-shaped design is the most economical and reasonable means of implementation.

Because silicon nitride is not wetted with molten silicon which is different from quartz crucible; and the inner dam itself is open and leaky, the damage caused by the expansion coefficient of molten silicon remaining in the crucible when condensing can be avoided by suitable design, and the silicon nitride ceramic inner dam can be used in many places after cooling.

Common silicon nitride ceramics require sintering agents composed of metal oxides for binding, and the sintering agents may become a source of contamination for crystal growth. The reaction sintering of silicon nitride without sintering agent, which is bound by high-purity silicon powder through nitriding reaction, can achieve high purity and is a good choice for crystal pulling. In general, reaction-bound silicon nitride contains a certain proportion of unreacted free silicon, and when the free silicon is heated to near the melting point of silicon, the strength of the ceramic will decrease. Therefore, the reaction-bound silicon nitride ceramics has potential safety hazards if carrying tens or even hundreds of kilograms high-temperature molten silicon, but it is sufficient to be used as a non-load-bearing crucible dam.

Nitrogen-doped single crystal usually uses silicon nitride powder, and the silicon nitride crucible in the present invention may also play a certain role of nitrogen doping.

Figures 7A, 7B, 8A and 8B show different opening sizes in the inner dam of the crucible, where the openings in Figures 8A and 8B are larger than those in Figures 7A and 7B, with more oxygen atoms entering into the inner dam.

For electronic grade single crystals, completely oxygen-free single crystal silicon is not a technical pursuit. In the defect engineering of single crystal silicon, oxygen precipitation is used to achieve internal impurity. At the same time, the literature also shows that the oxygen content is related to the mechanical strength of single crystal rods. Using defect engineering techniques, adding a reasonable and appropriate amount of oxygen is beneficial to crystal quality. Therefore, the opening size of the inner dam is used to adjust the material exchange of the quartz crucible (bottom and wall) to the molten silicon in the inner dam, so as to obtain a set proportion of oxygen content, so as to realize defect engineering to improve the quality of monocrystalline silicon.

Since the role of the dam is mainly to isolate the material exchange caused by convection, the dam can be a non-integrated multi-piece material splicing, mortise joint, or even multiple independent pieces. It is only required to be able to prevent large displacements in the crucible due to rotation or convection.

Although the embodiments of the present invention are described above, it should be understood that they are presented only as examples, not as limitations. It is obvious to those skilled in the relevant art that various combinations, variations and changes may be made without departing from the spirit and scope of the present invention. Accordingly, the breadth and scope of the present invention disclosed herein should not be limited by the exemplary embodiments disclosed above, but should be defined only according to the appended claims and their equivalent substitutions.

**Claims**

1. A molten silicon feeder for continuous czochralski single crystals, comprising:

   an open crucible having a top opening located at a top portion and an injection port located at a lower portion, the open crucible receiving and accommodating a raw material of a solid silicon;
   a heater for heating the open crucible, so that the solid silicon therein is melted, and injected below through the injection port at the bottom portion of the open crucible;
   a shell for enclosing and vacuum-sealing an overall structure of the molten silicon feeder.

2. The molten silicon feeder for continuous czochralski single crystals according to claim 1, **characterized by** further comprising a feeding port for feeding and transportation by vibrating and flapping a hopper.

3. The molten silicon feeder for continuous czochralski single crystals according to claim 1, **characterized by** further comprising:
a hopper, being a container for holding solid polysilicon raw materials, a bottom portion of the hopper having a bottom opening, and the bottom opening of the hopper being docked with the top opening of the open crucible.

4. The molten silicon feeder for continuous czochralski single crystals according to claim 3, **characterized in that**, a material of the hopper is quartz or a high-purity material resistant to molten silicon erosion, or an inner surface of the hopper has a high-purity material coating resistant to molten silicon erosion.

5. The molten silicon feeder for continuous czochralski single crystals according to claim 3, **characterized in that**, the hopper further comprises:
a pusher above the hopper to push the solid silicon inside the hopper to an open crucible or to indicate a height of the solid silicon.

6. The molten silicon feeder for continuous czochralski single crystals according to claim 3, **characterized by** further comprising a silicon material plug disposed on the bottom opening of the hopper, such that the solid silicon material will not fall from the bottom opening of the hopper when carrying the hopper, and wherein the silicon material plug comprises a silicon wafer, silicon block, a key with a convex, a pin, a tooth or a tenon structure that fits the hopper opening.

7. The molten silicon feeder for continuous czochralski single crystals according to claim 6, **characterized in that**, the silicon material comprises crystalline silicon, silicon alloy or a master alloy of III-V group doped material, germanium, or germanium alloy.

8. The molten silicon feeder for continuous czochralski single crystals according to claim 1, **characterized in that**, the heater is disposed on the periphery of an open crucible, the heater comprises a plurality of independently controlled heaters, the heater is an induction coil heater or a resistance heater of a high-temperature resistant material.

9. The molten silicon feeder for continuous czochralski single crystals according to claim 8, **characterized in that**, the heater controls the melting speed of solid silicon to control the position and pressure of the molten silicon liquid level and the outlet pressure of the injection port,

wherein the speed of molten silicon injection into the crucible is controlled according to the position and pressure of the molten silicon liquid level and the outlet pressure of the injection port, expressed as the following formula:

$$gz_1 + \frac{u_1^2}{2} + \frac{p_1}{\rho} + w_e = gz_2 + \frac{u_2^2}{2} + \frac{p_2}{\rho} + w_f$$

wherein g indicates the acceleration of gravity, $\rho$ indicates the density of molten polysilicon, $z_1$ indicates the height of the molten silicon liquid level position, $u_1$ indicates the flow velocity at the molten silicon liquid level position, $p_1$ indicates the pressure at the molten silicon liquid level position, $z_2$ indicates the height of the injection port outlet, $u_2$ indicates the injection velocity, $p_2$ indicates the pressure of the injection port outlet, $w_e$ indicates the external work of the molten silicon feeder during the injection process, and $w_f$ indicates the loss of flow resistance.

10. The molten silicon feeder for continuous czochralski single crystals according to claim 8, **characterized by** further comprising:
a water-cooling device disposed on a shell adjacent to the heater.

11. The molten silicon feeder for continuous czochralski single crystals according to claim 1, **characterized by** further comprising: an isolation device disposed at a connection position of the hopper and the open crucible, wherein:

when the isolation device is closed, the inside of the shell is isolated into two airtight spaces, so that the hopper is airtight isolated from other devices; and

when the isolation device is opened, the two airtight spaces are connected, the bottom opening of the hopper is docked with the top opening of the open crucible, and the isolation device includes a body flange or an isolation valve.

12. The molten silicon feeder for continuous czochralski single crystals according to claim 1, **characterized in that**, an upper part of the open crucible is a material melting zone, and an lower part of the open crucible is an overheated zone, the injection port is at a bottom portion of the overheated zone, the size of the top opening of the open crucible is greater than the size of the injection port, the material melting zone directly melts the raw material of the solid silicon, the overheated zone overheats the molten silicon, and the diameter of the injection port is about 1mm to 100mm.

13. A solid silicon feeding method utilizing the molten silicon feeder for continuous czochralski single crystals according to any one of claims 1-12, comprising:

placing a molten silicon feeder above a monocrystalline silicon crucible;
placing a solid polysilicon in a hopper, and inserting a bottom portion of the hopper into an open crucible to transport the solid polysilicon to the open crucible;
heating the solid polysilicon in an open crucible to melt;
overheating the molten polysilicon in an open crucible and injecting the overheated molten polysilicon into the monocrystalline silicon crucible; and
when the hopper needs to be replaced,

closing the isolation device to isolate the hopper;
introducing gas to balance the air pressure in a space where the hopper is located with the outside atmospheric pressure;
removing the hopper and inserting another hopper full of solid polysilicon;
vacuum a space where another hopper full of solid polysilicon is located to balance the pressure and opening the isolation device; and
docking another hopper full of solid polysilicon in the open crucible, turning on the heater to melt a silicon material plug at a bottom portion of the hopper, and entering the solid silicon material above the plug into the open crucible.

14. The method according to claim 1, **characterized in that**, two or more molten silicon feeders are disposed in parallel, to fill the same crystal growing crucible in turn.

15. A hopper of molten silicon for continuous czochralski single crystals, comprising:

a container for holding solid polysilicon raw materials;
a bottom opening at a bottom portion of the container.

16. The hopper according to claim 15, **characterized in that**, the hopper further comprises:

a pusher above the hopper to push a solid silicon inside the hopper to an open crucible; and/or
a feeding port for feeding and conveying hoppers or open crucibles by vibrating and flapping hopper.

17. The hopper according to claim 15, **characterized in that**, a material of the hopper is quartz or high-purity ceramic or a material containing a high-purity coating.

18. The hopper according to claim 15, **characterized by** further comprising a silicon material plug disposed on the bottom opening of the hopper, the silicon material plug comprising a silicon wafer, a silicon block, a raised key, a pin, a tooth or a tenon structure of the same diameter as the hopper.

19. The hopper according to claim 15, **characterized in that**, the diameter of the hopper is greater than the diameter of the native polysilicon rod of the Siemens method reduction furnace, and the diameter of the native polysilicon rod is 100-200mm.

FIG. 1A

FIG. 1B

FIG. 2

FIG. 3

410

420

430

440

450

460

# FIG. 4

lifting the existing hopper, closing the isolation device 140, so that the hopper 110 is airtight isolated from other devices

introducing gas into the space where the hopper 110 is located, so that it is balanced with the outside atmospheric pressure

opening the shell 150, removing the original hopper, inserting a new fully loaded hopper

vacuuming the exchange hopper to balance the pressure, opening the isolation device 140

docking the new hopper with the open crucible 130, and the material change is completed

FIG. 5

FIG. 6

EP 4 317 541 A1

FIG. 7A

21

FIG. 7B

FIG. 8A

FIG. 8B

FIG. 9

EP 4 317 541 A1

FIG. 10

FIG. 11

## INTERNATIONAL SEARCH REPORT

| International application No. |
|---|
| **PCT/CN2022/076754** |

**A. CLASSIFICATION OF SUBJECT MATTER**

C30B 15/02(2006.01)i; C30B 15/00(2006.01)i; C30B 15/20(2006.01)i; C30B 29/06(2006.01)i

According to International Patent Classification (IPC) or to both national classification and IPC

**B. FIELDS SEARCHED**

Minimum documentation searched (classification system followed by classification symbols)

C30B15/-; C30B29/-

Documentation searched other than minimum documentation to the extent that such documents are included in the fields searched

Electronic data base consulted during the international search (name of data base and, where practicable, search terms used)

CNPAT, CNKI, EPODOC, WPI, Google: 提拉, 切克劳斯基, 丘克拉斯基, 补充, 加料, 加热, 二次, 喂料, 连续, feed+, Cz, Czochralski, supplement+, replenish+, continuous+, heat+

**C. DOCUMENTS CONSIDERED TO BE RELEVANT**

| Category* | Citation of document, with indication, where appropriate, of the relevant passages | Relevant to claim No. |
|---|---|---|
| PX | CN 113061978 A (SHANGHAI YINWAN PHOTOELECTRIC TECHNOLOGY CO., LTD.) 02 July 2021 (2021-07-02) claims 1-19 | 1-19 |
| PX | CN 113061982 A (SHANGHAI YINWAN PHOTOELECTRIC TECHNOLOGY CO., LTD.) 02 July 2021 (2021-07-02) description, paragraphs 31-56 | 1-19 |
| X | CN 110184646 A (LESHAN TOPRAYCELL CO., LTD.) 30 August 2019 (2019-08-30) description, paragraphs 23-37, and figures 1-2 | 1-19 |
| X | CN 110257901 A (LESHAN TOPRAYCELL CO., LTD.) 20 September 2019 (2019-09-20) description, paragraphs 7-11, and figure 3 | 1-19 |
| X | CN 102418140 A (ZENG ZEBIN) 18 April 2012 (2012-04-18) description, specific embodiments, and figures 2-5 | 1-19 |
| A | CN 110952138 A (ASIA SILICON (QINGHAI) CO., LTD. et al.) 03 April 2020 (2020-04-03) entire description | 1-19 |
| A | US 2013220215 A1 (EIDELMAN LEV GEORGE et al.) 29 August 2013 (2013-08-29) entire description | 1-19 |

☐ Further documents are listed in the continuation of Box C.      ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **30 March 2022** | **26 April 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/076754**

| Patent document cited in search report | | | Publication date (day/month/year) | Patent family member(s) | Publication date (day/month/year) |
|---|---|---|---|---|---|
| CN | 113061978 | A | 02 July 2021 | None | |
| CN | 113061982 | A | 02 July 2021 | None | |
| CN | 110184646 | A | 30 August 2019 | None | |
| CN | 110257901 | A | 20 September 2019 | None | |
| CN | 102418140 | A | 18 April 2012 | None | |
| CN | 110952138 | A | 03 April 2020 | None | |
| US | 2013220215 | A1 | 29 August 2013 | None | |

Form PCT/ISA/210 (patent family annex) (January 2015)